# EUROPEAN PATENT SPECIFICATION

(11) **EP 3 929 924 B1**
(45) Date of publication and mention of the grant of the patent: **07.06.2023**
(21) Application number: 20878750.7
(22) Date of filing: 22.06.2020
(51) Int. Cl.: G11C 11/4093, G11C 7/02, G11C 7/10, G11C 11/4096

(54) **WRITE OPERATION CIRCUIT, SEMICONDUCTOR MEMORY AND WRITE OPERATION METHOD**
SCHREIBOPERATIONSSCHALTUNG, HALBLEITERSPEICHER UND SCHREIBOPERATIONSVERFAHREN
CIRCUIT D'OPÉRATION D'ÉCRITURE, MÉMOIRE À SEMI-CONDUCTEURS ET PROCÉDÉ D'OPÉRATION D'ÉCRITURE

(30) Priority: 25.10.2019 CN 201911021589
(43) Date of publication of application: 29.12.2021
(73) Proprietor: Changxin Memory Technologies, Inc., Hefei, Anhui 230000 (CN)
(72) Inventor: ZHANG, Liang, Shanghai 200336 (CN)
(74) Representative: V.O.
(86) International application number: PCT/CN2020/097350
(87) International publication number: WO 2021/077774

(56) References cited:
- CN-A- 1 702 768
- CN-A- 104 272 389
- CN-A- 108 630 255
- CN-A- 109 643 563
- KR-B1- 100 625 818
- US-A- 5 216 637
- US-A- 6 097 209
- US-A1- 2007 115 733
- US-A1- 2010 042 889

## Description

### TECHNICAL FIELD

The present disclosure relates to the technical field of semiconductor memory, and particularly, to a write operation circuit, a semiconductor memory, and a write operation method.

### BACKGROUND

Semiconductor memory includes Static Random-Access Memory (SRAM), Dynamic Random Access Memory (DRAM), Synchronous Dynamic Random Access Memory (SDRAM), Read-Only Memory (ROM), Flash memory, and the like.

In the DRAM protocol made by Joint Electron Device Engineering Council (JEDEC), there are specific requirements on speed and power saving of DRAM. How to make DRAM more power-saving while also ensuring the signal integrity and the reliability of data transmission and storage is a problem urgently to be solved in the industry.

The related technologies are known from US 2010/042889 A1, KR 100625818 B1 and US 6097209 A.

### SUMMARY

The invention is set out in the appended set of claims.

Embodiments of the present disclosure provide a write operation circuit, a semiconductor memory, and a write operation method to solve or alleviate one or more technical problems in the existing technologies.

In a first aspect, the invention provides a write operation circuit that is used in a semiconductor memory. The write operation circuit includes a data determination module, a data buffer module, a data receiving module, and a precharge module.

The data determination module is configured to determine, according to a number of low-level bits in input data of the semiconductor memory, whether to invert the input data to generate inversion flag data and first intermediate data.

The data buffer module includes a plurality of NMOS transistors and a plurality of first inverters. A gate electrode of each of the plurality of NMOS transistors is connected to the data determination module through a respective one of the plurality of first inverters to receive second intermediate data. A drain electrode of each of the plurality of NMOS transistors is connected to a global bus. The data buffer module is configured to determine, according to second intermediate data, whether to invert the global bus, where the second intermediate data is inverted data of the first intermediate data.

The data receiving module is connected to a storage bank. The data receiving module receives global bus data through the global bus, receives the inversion flag data through the inversion flag signal line, decodes the global bus data according to the inversion flag data and writes the decoded data into the storage bank of the semiconductor memory. The decoding includes determining whether to invert the global bus data. An input terminal of the data receiving module is connected to the global bus and the inversion flag signal line.

The precharge module connected to a precharge signal line and configured to set an initial state of the global bus to high.

In an implementation mode, the write operation circuit further includes a serial-to-parallel conversion circuit connected between a DQ port of the semiconductor memory and the data determination module. The serial-to-parallel conversion circuit is configured to perform serial-to-parallel conversion on first input data at the DQ port to generate second input data, and the data determination module is configured to determine, according to a number of low-level bits in the second input data, whether to invert the second input data to generate the inversion flag data and first intermediate data.

In an implementation mode, the second input data is divided into M groups, the inversion flag data has M bits, and the M bits of the inversion flag data are in one-to-one correspondence with the M groups of second input data. Each of the M groups of second input data has N bits, N and M are integers greater than 1. The data determination module is configured to, when a number of low-level bits in a group of second input data inputted to the data determination module is greater than N/2, output inversed data of the group of second input data as a group of first intermediate data corresponding to the group of second input data and set one bit of the inversion flag data corresponding to the group of second input data to high; and when the number of low-level bits in the group of second input data inputted to the data determination module is less than or equal to N/2, output the group of second input data as the group of first intermediate data corresponding to the group of second input data and set one bit of the inversion flag data corresponding to the group of second input data to low.

In an implementation mode, the data determination module includes a data determination unit and a data selector.

An input terminal of the data determination unit is connected to the serial-to-parallel conversion circuit, and an output terminal of the data determination unit is connected to the inversion flag signal line. The data determination unit is configured to set the inversion flag data to high when the number of low-level bits in the second input data is greater than a preset value, and set the inversion flag data to low when the number of low-level bits in the second input data is less than or equal to the preset value.

An input terminal of the data selector is connected to the data determination unit and is configured to receive the second input data through the data determination unit, the input terminal of the data selector further receives the inversion flag data through the inversion flag signal line, and an output terminal of the data selector is connected to an input terminal of the first inverter. The data selector is configured to output inverted data of the second input data as the first intermediate data when the inversion flag data is high, and output the original second input data as the first intermediate data when the inversion flag data is low.

In an implementation mode, the data selector includes a plurality of data selection units, and each of the plurality of data selection units includes: a second inverter, a third inverter, a first transmission gate, and a second transmission gate.

An input terminal of the second inverter receives the inversion flag data through the inversion flag signal line.

An input terminal of the third inverter is connected to the data determination unit and is configured to receive the second input data from the data determination unit.

An input terminal of the first transmission gate is connected to an output terminal of the third inverter, an output terminal of the first transmission gate is connected to the input terminal of the first inverter and is configured to output the first intermediate data, a negative control terminal of the first transmission gate is connected to an output terminal of the second inverter, and a positive control terminal of the first transmission gate receives the inversion flag data through the inversion flag signal line.

An input terminal of the second transmission gate is connected to the data determination unit and is configured to receive the second input data from the data determination unit, an output terminal of the second transmission gate is connected to the input terminal of the first inverter and is configured to output the first intermediate data, a negative control terminal of the second transmission gate receives the inversion flag data through the inversion flag signal line, and a positive control terminal of the second transmission gate is connected to the output terminal of the second inverter.

In an implementation mode, the global bus data is divided into M groups, and the M bits of the inversion flag data are in one-to-one correspondence with the M groups of global bus data. The data receiving module includes M data receiving units, and each of the M data receiving units is connected to the storage bank and is configured to decode the corresponding group of global bus data according to one bit of the inversion flag data.

In an implementation mode, the data receiving unit includes: a fourth inverter, a fifth inverter, a third transmission gate, and a fourth transmission gate.

An input terminal of the fourth inverter receives the inversion flag data through the inversion flag signal line.

An input terminal of the fifth inverter receives the global bus data through the global bus.

An input terminal of the third transmission gate is connected to an output terminal of the fifth inverter, an output terminal of the third transmission gate is connected to the storage bank and is configured to output the decoded data to the storage bank, a negative control terminal of the third transmission gate is connected to an output terminal of the fourth inverter, and a positive control terminal of the third transmission gate receives the inversion flag data through the inversion flag signal line.

An input terminal of the fourth transmission gate receives the global bus data through the global bus, an output terminal of the fourth transmission gate is connected to the storage bank and is configured to output the decoded data to the storage bank, a negative control terminal of the third transmission gate receives the inversion flag data through the inversion flag signal line, and a positive control terminal of the third transmission gate is connected to the output terminal of the fourth inverter.

In an implementation mode, the precharge module includes a plurality of PMOS transistors and a plurality of hold circuits. A gate electrode of each of the plurality of PMOS transistors is connected to the precharge signal line, a drain electrode of each of the plurality of PMOS transistors is connected to the global bus, and an input terminal and an output terminal of the hold circuit are both connected to the global bus.

In a second aspect, embodiments of the present disclosure provide a semiconductor memory, which includes the write operation circuit according to any one of the above embodiments.

In a third aspect, embodiments of the present disclosure provide a write operation method applied to a semiconductor memory. The write operation method includes the following operations.

An initial state of a global bus is set to high;
It is determined whether to invert the input data according to a number of low-level bits in input data of the semiconductor memory, to generate inversion flag data and first intermediate data.

It is determined whether to invert global bus data according to second intermediate data, where the second intermediate data is inverted data of the first intermediate data.

The global bus data is decoded according to the inversion flag data, where the decoding includes determining whether to invert the global bus data.

The decoded data is written into a storage bank.

In an implementation mode, the operation in which it is determined whether to invert the input data according to the number of low-level bits in input data of the semiconductor memory, to generate the inversion flag data and the first intermediate data includes the following operations.

Serial-to-parallel conversion is performed on first input data at a DQ port to generate second input data.

It is determined whether to invert the second input data according to a number of low-level bits in the second input data, to generate inversion flag data and first intermediate data.

In an implementation mode, the operation in which, it is determined whether to invert the second input data according to the number of low-level bits in the second input data, to generate inversion flag data and first intermediate data includes the following operations.

The second input data is divided into M groups, where each group of second input data has N bits, and M and N are integers greater than 1.

When a number of low-level bits in an inputted group of second input data is greater than N/2, inverted data of the inputted group of second input data is outputted as a corresponding group of first intermediate data, and one bit of the inversion flag data corresponding to the inputted group of second input data is set to high; and
When the number of low-level bits in the inputted group of second input data inputted to the data determination module is less than or equal to N/2, the inputted group of second input data is inputted as the corresponding group of first intermediate data, and one bit of the inversion flag data corresponding to the inputted group of second input data is set to low.

By using the above technical solutions, the embodiments of the present disclosure can reduce the number of inversions of the global bus in a Precharge-High architecture, thereby greatly reducing a current and decreasing power consumption.

The above is only for the purpose of description and is not intended to be limiting in any way. In addition to the illustrative aspects, embodiments and features described above, further aspects, embodiments and features of this disclosure can be easily understood by referring to the drawings and the following detailed description.

### BRIEF DESCRIPTION OF THE DRAWINGS

In the drawings, unless otherwise specified, the same reference numerals denote the same or similar parts or elements throughout the multiple drawings. The drawings are not necessarily drawn to scale. It should be understood that these drawings only depict some embodiments disclosed according to the present disclosure, and should not be regarded as limiting of the scope of the present disclosure.
FIG. 1 shows a schematic block diagram of a part of a semiconductor memory according to an implementation mode of an embodiment of the present disclosure;
FIG. 2 shows a schematic block diagram of a part of a semiconductor memory according to another implementation mode of the embodiment of the present disclosure;
FIG. 3 shows a schematic circuit diagram of a data buffer module and a precharge module (corresponding to one storage bank) according to an implementation mode of the embodiment of the present disclosure;
FIG. 4 shows a schematic circuit diagram of a data buffer module and a precharge module (corresponding to multiple storage banks) according to an implementation mode of the embodiment of the present disclosure;
FIG. 5 shows a schematic block diagram of a data determination module according to an implementation mode of the embodiment of the present disclosure;
FIG. 6 shows a schematic block diagram of a data selection unit according to an implementation of the embodiment mode of the present disclosure;
FIG. 7 shows a schematic block diagram of a data receiving module according to an implementation of the embodiment mode of the present disclosure;
FIG. 8 shows a schematic block diagram of a data receiving unit according to an implementation of the embodiment mode of the present disclosure; and
FIG. 9 shows a schematic flowchart of a write operation method according to an implementation mode of the embodiment of the present disclosure.

### Reference numerals in the accompanying drawings:

20: Semiconductor memory;
21: Serial-to-parallel conversion circuit;
22: Data buffer module;
23: Data determination module;
24: DQ port;
25: Data receiving module;
26: Storage bank;
27: Precharge module;
221: PMOS transistor;
222: NMOS transistor;
223: Hold circuit;
224: First inverter;
231: Data determination unit;
232: Data selector;
232': Data selection unit;
232A: Second inverter;
232B: Third inverter;
232C: First transmission gate;
232D: Second transmission gate;
250: Data receiving unit;
251: Fourth inverter;
252: Fifth inverter;
253: Third transmission gate; and
254: Fourth transmission gate.

### DETAILED DESCRIPTION

Exemplary embodiments will be described more comprehensively with reference to the accompanying drawings. However, the exemplary embodiments can be implemented in various forms, and should not be construed as being limited to the embodiments set forth herein. On the contrary, these embodiments are provided so that this disclosure will be comprehensive and complete, and will fully convey the concept of the exemplary embodiments to those skilled in the art. In the drawings, the same reference numerals denote the same or similar elements, and thus their repeated description will be omitted.

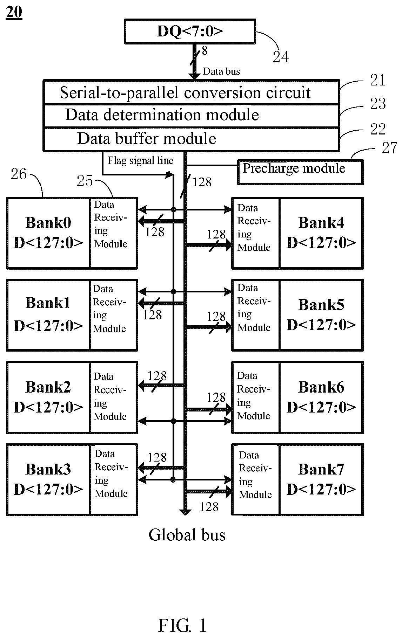

FIG. 1 shows a schematic block diagram of a part of a semiconductor memory according to an implementation mode of an embodiment of the present disclosure. As shown in FIG. 1, a semiconductor memory 20 includes a DQ port 24, a storage bank 26, and a write operation circuit. The write operation circuit includes a global bus, an inversion flag signal line, a serial-to-parallel conversion circuit 21, a data termination module 23, a data buffer module 22, a data receiving module 25, and a precharge module 27. In an implementation mode, the semiconductor memory 20 is Dynamic Random Access Memory (DRAM), for example, Double Data Rate SDRAM 4 (abbreviated as DDR4).

In an example, as shown in FIG. 1, the write operation circuit receives 8-bit first input data DQ<7:0> through the DQ port 24, and writes write data (i.e., decoded data) D<127:0> into the storage bank 26. One Active command enables the only one designated storage bank 26. The write operation is executed per storage bank 26. That is, when one storage bank of eight storage banks 26 (i.e., Bank<7:0>) is working, the other storage banks are not working. It should be noted that, the number of the storage banks 26, the number of data bits of each storage bank 26, the number of data bits of the DQ port 24, and the number of the DQ port 24 are not limited in embodiments of the present disclosure. For example, there may be one DQ port 24 for inputting 8-bit first input data. For another example, there may be two DQ ports 24, which are respectively used for inputting 8-bit first input data DQ<7:0> and 8-bit first input data DQ<15:8>, and thus 16-bit first input data DQ <15:0> is inputted.

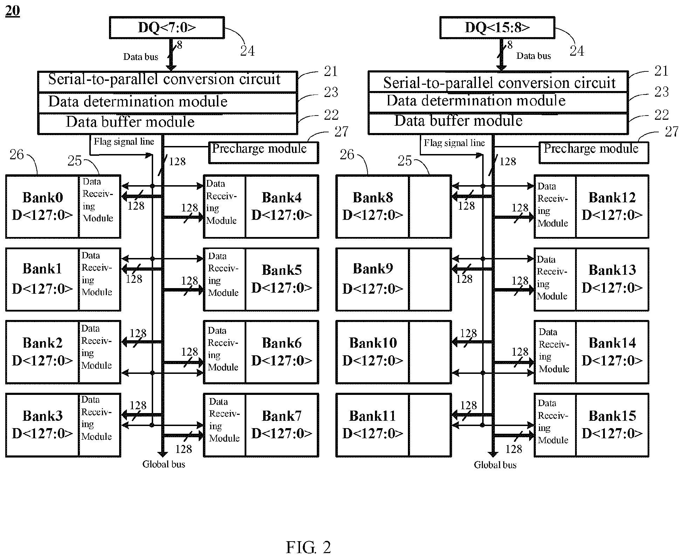

For example, as shown in FIG. 2, an write operation of the first input data DQ<7:0> for a group of storage banks <7:0> is executed by one write operation circuit, and an write operation of the first input data DQ<15:8> for another group of storage banks <15:8> is executed by another write operation circuit. Accordingly, among the eight storage banks 26 (i.e., Bank<15:8>) corresponding to DQ<15:8>, only one storage bank is working, the other storage banks are not working. '

The semiconductor memory 20 is in an array structure, and the structure of each unit may be the same. However, the output data of the units may be different due to different input data. The write operation circuit of the present embodiment is described below by taking one storage bank as an example.

As shown in FIG. 1 and FIG. 2, the write operation circuit of the present embodiment includes a data determination module 23, which is configured to determine, according to the number of low-level bits in the input data of the semiconductor memory 20, whether to invert the input data to generate inversion flag data and first intermediate data.

In an implementation mode, the data determination module 23 is configured to: when the number of low-level bits in the input data is greater than a preset value, output inverted data of the input data as the first intermediate data and set inversion flag data to high; when the number of low-level bits in the input data is less than or equal to the preset value, output the original input data as the first intermediate data and set inversion flag data to low.

For example, the input data has 8 bits. If the number of bits "0" in the input data is greater than half of the total number of bits of the input data, that is, greater than 4 (for example, the number of bits "0" is 5), Flag is 1, and the outputted first intermediate data is the inverted data of the input data. If the number of bits "0" in the input data is less than half of the total number of bits of the input data, for example, the number of bits "0" is 3, Flag is 0, and the outputted first intermediate data is the original input data.

The data being high means that the data is "1", and the data being low means that the data is "0". The data inversion means inverting from "0" to "1", or inverting from "1" to "0". The inversion of a data line or a signal line can be understood as changing from a high level to a low level, or changing from a low level to a high level.

In an implementation mode, the write operation circuit includes a serial-to-parallel conversion circuit 21. The serial-to-parallel conversion circuit 21 is connected between the DQ port 24 and the data determination module 23, and is configured to perform serial-to-parallel conversion on the first input data at the DQ port 24 to generate second input data. For example, the serial-to-parallel conversion circuit 21 performs serial-to-parallel conversion on 8-bit first input data DQ<7:0> to generate 128-bit second input data D2'<127:0> corresponding to the storage bank Bank0.

In an implementation mode, the second input data D2'<127:0> is divided into M groups, and the inversion flag data Flag has M bits. The M bits of the inversion flag data Flag are in one-to-one correspondence with the M groups of second input data, and each group of second input data has N bits, where N and M are integers greater than 1. The data determination module 23 is configured to: w hen the number of low-level bits in an inputted group of second input data is greater than N/2, output the inverted data of the inputted group of second input data as a group of first intermediate data corresponding to the inputted group of second input data and set one bit of the inversion flag data corresponding to the inputted group of second input data to high; and when the number of low-level bits in the inputted group of second input data is less than or equal to N/2, output the inputted group of second input data as the group of first intermediate data corresponding to the inputted group of second input data and set one bit of the inversion flag data corresponding to the inputted group of second input data to low.

For example, the second input data D2'<127:0> is divided into 16 groups, and each group of second input data has 8 bits and corresponds to one bit of the inversion flag data Flag. Accordingly, the inversion flag data Flag has 16 bits, such as Flag<15:0>. The first intermediate data D1'<127:0> is divided into 16 groups accordingly. Each bit of the inversion flag data Flag corresponds one group of first intermediate data. For a group of second input data D2'<127: 120>, if the number of bits "0" in D2'<127: 120> is greater than 4, the corresponding bit of the inversion flag data Flag<15> is 1, the outputted group of first intermediate data D1'<127:120> is the inverted data of the group of second input data D2'<127: 120>. If the number of bits "0" in D2'<127: 120> is less than or equal to 4, the corresponding bit of the inversion flag data Flag<15> is 0, and the outputted group of first intermediate data D1'<127:120> is the group of second input data D2'<127:120>. Similarly, for the group of second input data D2'<15:8>, if the number of bits "0" in D2'<15:8> is greater than 4, the corresponding bit of the inversion flag data Flag<1> is 1, the outputted group of first intermediate data D1'<15:8> is the inverted data of the group of second input data D2'<15:8>. If the number of bits "0" in D2'<15:8> is less than or equal to 4, the corresponding bit of the inversion flag data Flag<1> is 0, and the outputted group of first intermediate data D1'<15:8> is the group of second input data D2'<15:8>. For the group of second input data D2'<7:0>, if the number of bits "0" in D2'<7:0> is greater than 4, the corresponding bit of the inversion flag data Flag<0> is 1, the outputted group of first intermediate data D1'<7:0> is the inverted data of the group of second input data D2'<7:0>. If the number of bits "0" in D2'<7:0> is less than or equal to 4, the corresponding bit of the inversion flag data Flag<0> is 0, and the outputted group of first intermediate data D1'<7:0> is the group of second input data D2'<7:0>. In this way, there is more data "0" in the first intermediate data D1'<127:0>.

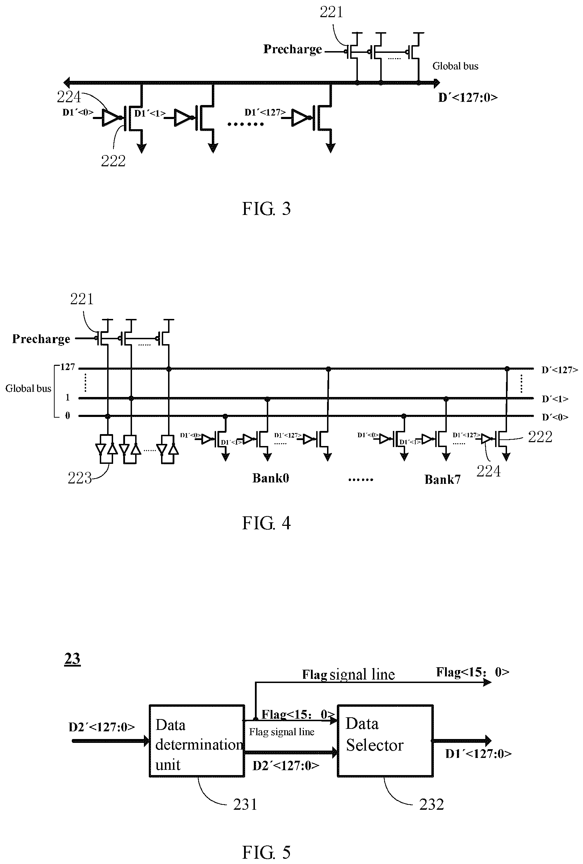

Furthermore, the semiconductor memory 20 of the present embodiment further includes a data buffer module 22 and a precharge module 27. FIG. 3 shows a schematic circuit diagram of the data buffer module 22 (corresponding to one storage bank 26) according to an implementation mode of the present embodiment. FIG. 4 shows a schematic circuit diagram of the data buffer module 22 (corresponding to 8 storage banks 26) according to an implementation mode of the present embodiment.

As shown in FIG. 3 and FIG. 4, the data buffer module 22 includes a plurality of Negative Channel Metal Oxide Semiconductor (NMOS) transistors 222 and a plurality of first inverters 224. A gate electrode of the NMOS transistor 222 is connected to the data determination module 23 through the corresponding first inverter 224, and a drain electrode of the NMOS transistor 222 is connected to the global bus. The first inverter 224 is configured to perform negation operation on the first intermediate data to generate the second intermediate data, such that the data buffer module 22 determines whether to invert the global bus according to the second intermediate data. Since there is more data "1" in the first intermediate data, there is more data "0" in the second intermediate data.

The precharge module 27 is connected to a precharge signal line Precharge, and is configured to set an initial state of the global bus to low. That is, the global bus of the semiconductor memory 20 of the present embodiment adopts a Precharge-High transmission configuration. Specifically, the precharge module 27 includes a plurality of Positive Channel Metal Oxide Semiconductor (PMOS) transistors 221 and a plurality of hold circuits 223. A gate electrode of the PMOS transistor 221 is connected to the precharge signal line, and a drain electrode of the PMOS transistor 221 is connected to the global bus. An input terminal and an output terminal of the hold circuit 223 are connected to the global bus to form a positive feedback circuit.

The function of Precharge is to set the initial state of each global bus to High, and the specific process is as follows. A pull-up pulse (about 2ns) is generated on the precharge signal line Precharge, and the pull-up pulse pulls up the potential of the corresponding global bus for a moment, the hold circuit 223 forms a positive feedback, and the potential of the global bus is locked to the high level. However, the hold circuit 223 has a poor current pull-up capability and a poor current pull-down capability. When it needs to change the potential of a certain global bus to low level, the potential of the data line (the data line connected to the gate electrode of the corresponding NMOS transistor 222) corresponding to this global bus is pulled up (that is, a pulse, about 2ns, is applied), and accordingly, the corresponding NMOS transistor 222 pulls down the potential of this global bus for a moment (the pull-down capability is stronger than the pull-up capability of the hold circuit 223), and then the potential of this global bus is locked to the low level through positive feedback, thereby achieving the inversion operation of the data line. There is more data "1" in the second intermediate data, and thus fewer inversions are required. Therefore, the IDD4W (write current) of the semiconductor memory will be reduced, such that the power consumption of the semiconductor memory can be reduced.

In an example, there are a plurality of global buses, and the plurality of global buses are arranged in M groups, where M is an integer greater than 1. Each global bus transmits one bit of the global bus data. For example, there are 128 global buses, the global bus <0> transmits the global bus data D'<0>, the global bus <1> transmits the global bus data D'<1>; ......; the global bus <127> transmits the global bus data D'<127>. The 128 global buses are arranged in 16 groups.

In an example, each inversion flag data Flag corresponds to one group of global bus data. Accordingly, there are 16 Flag signal lines (inversion flag signal lines), and the Flag data (inversion flag data) has 16 bits, for example, Flag<15:0>. Each Flag signal line transmits one bit of the Flag data. For example, a Flag signal line <0> transmits the Flag data Flag<0> and corresponds to the global bus data D'<7:0>, the Flag data Flag <0> indicates whether D'<0:7> is the inverted second intermediate data; a Flag signal line <1> transmits the Flag data Flag<1> and corresponds to the global bus data D'<15:8>, the Flag data Flag<1> indicates whether D'<15:8> is the inverted second intermediate data; ......; a Flag signal line <15> transmits the Flag data Flag<15> and corresponds to the global bus data D'<127:120>, the Flag data Flag<15> indicates whether D'<127:120> is the inverted second intermediate data.

Since the second intermediate data is the inverted data of the first intermediate data D1'<127:120>, when Flag<15>=1, the global bus data D'<127:120> = D1'<127:120>; and when Flag<15>=0, the global bus data D'<127:120> is the inverted data of D1'<127:120>. Similarly, when Flag<1>=1, the global bus data D'<15:8>= D1'<15:8>; and when Flag<1>=0, the global bus data D'<15:8> is the inverted data of D1'<15:8>. When Flag<0>=1, the global bus data D'<7:0>= D1'<7:0>; and when the Flag<0>=0, the global bus data D'<7:0> is the inverted data of D1'<7:0>.

In this way, there is more data "1" in the global bus data D'<127:0> transmitted on the global bus. Accordingly, for the semiconductor memory 20 shown in FIG. 2, there is more data "1" in the 256-bit global bus data (including the 128-bit global bus data corresponding to DQ<7:0> and the 128-bit global bus data corresponding to DQ<15:8>).

In an implementation mode, as shown in FIG. 5, the data determination module 23 includes a data determination unit 231 and a data selector 232.

An input terminal of the data determination unit 231 is connected to the serial-to-parallel conversion circuit 21. An output terminal of the data determination unit 231 is connected to the Flag signal line and an input terminal of the data selector 232. The data determination unit 231 is configured to set the Flag data to high when the number of low-level bits in the second input data is greater than the preset value, and set the Flag data to low when the number of low-level bits in the second input data is less than or equal to the preset value.

An input terminal of the data selector 232 is connected to the data determination unit 231 and is configured to receive the second input data through the data determination unit 231. An input terminal of the data selector 232 further receives the Flag data through the Flag signal line. An output terminal of the data selector 232 is connected to the input terminal of the first inverter 224. The data selector 232 is configured to output the inverted data of the second input data as the first intermediate data when the Flag data is high, and output the original second input data as the first intermediate data when the Flag data is low.

In an implementation mode, the data selector 232 includes multiple data selection units 232', and each data selection unit 232' is configured to process one bit of the Flag data and one group of second input data. For example, there are 16 data selection units 232', each of which corresponds to one of the 16 groups of second input data and one bit of the Flag data.

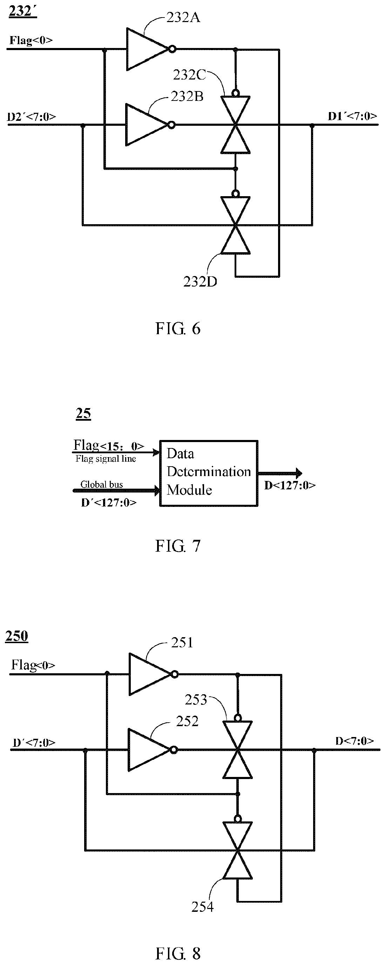

FIG. 6 shows an implementation mode of an exemplary data selection unit 232'. As shown in FIG. 6, the data selection unit 232' includes a second inverter 232A, a third inverter 232B, a first transmission gate 232C, and a second transmission gate 232D.

An input terminal of the second inverter 232A receives the Flag data through the Flag signal line. An input terminal of the third inverter 232B is connected to the data determination unit 231 and is configured to receive the second input data from the data determination unit 231. An input terminal of the first transmission gate 232C is connected to an output terminal of the third inverter 232B, and an output terminal of the first transmission gate 232C is connected to the input terminal of the first inverter 224 and is configured to output the first intermediate data. A negative control terminal (the upper control terminal in FIG. 6) of the first transmission gate 232C is connected to an output terminal of the second inverter 232A, and a positive control terminal (the lower control terminal in FIG. 6) of the first transmission gate 232C receives the Flag data through the Flag signal line. An input terminal of the second transmission gate 232D is connected to the data determination unit 231 and is configured to receive the second input data from the data determination unit 231. An output terminal of the second transmission gate 232D is connected to the input terminal of the first inverter 224 and is configured to output the first intermediate data. A negative control terminal of the second transmission gate 232D receives the Flag data through the Flag signal line, and a positive control terminal of the second transmission gate 232D is connected to an output terminal of the second inverter 232A.

Taking Flag<0> and the second input data D2'<7:0> as an example, as shown in FIG. 6, when Flag=1, the first intermediate data D1'<7:0> is the inverted data of the second input data D2'<7:0>; and when Flag=0, the first intermediate data D1'<7:0> is the second input data D2'<7:0>.

It should be noted that one group, including the third inverter 232B, the first transmission gate 232C and the second transmission gate 232D, is configured to process one bit of the second input data and output one corresponding bit of the second intermediate data. That is, for 8-bit second input data D2'<7:0>, eight groups of the third inverter 232B, the first transmission gate 232C and the second transmission gate 232D are required, and thus 8-bit first intermediate data D1'<7:0> may be outputted.

In view of the above, when the Flag data is 1, the global bus data D'<127:0> is the inverted data of the second input data D2'<127:0>; and when the Flag data is 0, the global bus data D'<127:0> is the original second input data D2'<127:0>.

As shown in FIG. 1, FIG. 2 and FIG. 7, the write operation circuit of the present embodiment further includes a data receiving module 25. An input terminal of the data receiving module 25 is connected to the global bus and the inversion flag signal line, and an output terminal of the data receiving module 25 is connected to the storage bank 26. The data receiving module 25 is configured to determine, according to the Flag data, whether to invert the global bus data (i.e., decode the global bus data) and write the decoded data (i.e., write date) into the storage bank 26. For example, when the Flag data is high, the inverted data of the global bus data is outputted as the write data; and when the Flag data is low, the original global bus data is outputted as the write data.

As a result, the write data is recovered to the input data of the semiconductor memory. Accordingly, neither data nor functions of an external port such as the DQ port 24 and a DBI port (not shown in the figures) of the semiconductor memory 20 will be changed.

In an implementation mode, the data receiving module 25 may include a plurality of data receiving units 250, and each of the plurality of the data receiving units 250 is configured to process one bit of the inversion flag data and one group of global bus data. For example, there may be 16 data receiving units 250, each of which corresponds to one of the 16 groups of global bus data and one bit of the inversion flag data. FIG. 8 illustrates an implementation mode of the data receiving unit 250.

As shown in FIG. 8, the data receiving unit 250 includes a fourth inverter 251, a fifth inverter 252, a third transmission gate 253, and a fourth transmission gate 254.

An input terminal of the fourth inverter 251 receives the inversion flag data through the inversion flag signal line. An input terminal of the fifth inverter 252 receives the global bus data through the global bus. An input terminal of the third transmission gate 253 is connected to an output terminal of the fifth inverter 252. An output terminal of the third transmission gate 253 is connected to the storage bank 26 and is configured to output the write data to the storage bank 26. A negative control terminal (the upper control terminal in FIG. 8) of the third transmission gate 253 is connected to an output terminal of the third inverter 251, and a positive control terminal of the third transmission gate 253 receives the inversion flag data through the inversion flag signal line. An input terminal of the fourth transmission gate 254 receives the global bus data through the global bus. An output terminal of the fourth transmission gate 254 is connected to the storage bank 26 and is configured to output the write data to the storage bank 26. A negative control terminal (the upper control terminal in FIG. 8) of the fourth transmission gate 254 receives the inversion flag data through the inversion flag signal line, and a positive control terminal (the lower control terminal in FIG. 8) of the fourth transmission gate 254 is connected to the output terminal of the fourth inverter 251.

Taking Flag<0> and the global bus data D'<7:0> as an example, as shown in FIG. 8, when Flag=1, the write data D<7:0> is the inverted data of the global bus data D'<7:0>; and when Flag=0, the write data D<7:0> is the global bus data D'<7:0>, that is, D<7:0>= D'<7:0>.

It should be noted that one group, including the fifth inverter 252, the third transmission gate 253, and the fourth transmission gate 254, is configured to process one bit of the global bus data and output one corresponding bit of the write data. That is, for 8-bit global bus data D'<7:0>, eight groups of the fifth inverter 252, the third transmission gate 253, and the fourth transmission gate 254 are required, and thus 8-bit write data D<7:0> can be outputted.

According to the semiconductor memory 20 of the present embodiment, in the process of writing data (DQ<7:0>=<00000000>; DQ<15:8>=<00000000>) into the semiconductor memory 20, the global bus data has 256 bits. If it needs to invert the 256-bit global bus data, it only needs to invert 32-bit inversion flag data, such that the IDD4W current will be reduced significantly.

In practical applications, the semiconductor memory 20 of the present embodiment also includes other structures such as a sense amplifier and a precharge circuit, which are not repeated in this embodiment because they belong to the prior art.

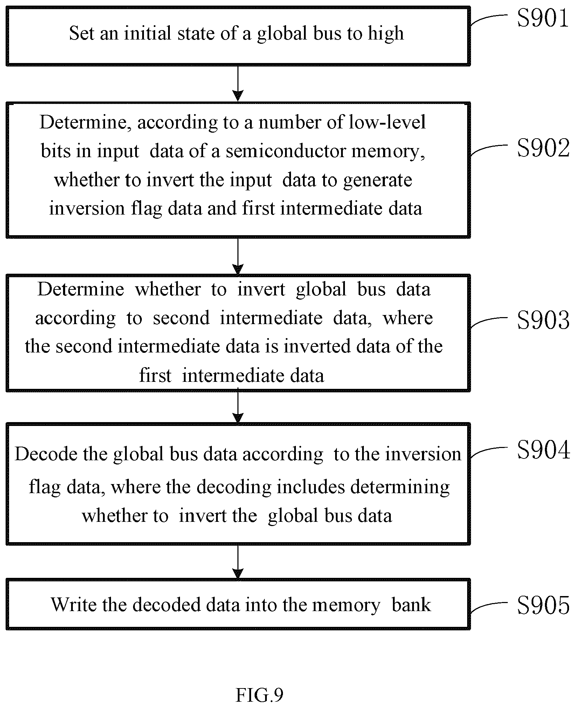

FIG. 9 shows a schematic flowchart of a write operation method according to the invention. The write operation method is applied in the above semiconductor memory 20. As shown in FIG. 9, the write operation method includes the following steps.

In step S901, an initial state of the global bus is set to high.

In step S902, it is determined whether to invert the input data to generate inversion flag data and first intermediate data according to the number of low-level bits in the input data of the semiconductor memory.

In step S903, it is determined whether to invert global bus data according to second intermediate data, where the second intermediate data is inverted data of the first intermediate data.

In step S904, the global bus data is decoded according to the inversion flag data, where the decoding includes determining whether to invert the global bus data.

In step S905, the decoded data is written into the storage bank.

In an implementation mode, the step S902 may include that: serial-to-parallel conversion is performed on first input data of a DQ port to generate second input data; and it is determined whether to invert the second input data to generate inversion flag data and first intermediate data according to a number of low-level bits in the second input data.

In an implementation mode, the step in which it is determined whether to invert the second input data to generate inversion flag data and first intermediate data according to the number of low-level bits in the second input data includes the following steps. The second input data is divided into M groups, where each group of second input data has N bits. When the number of low-level bits in an inputted group of second input data is greater than N/2, inverted data of the inputted group of second input data is outputted as a corresponding group of first intermediate data, and one bit of the inversion flag data corresponding to the inputted group of second input data is set to high. When the number of low-level bits in the inputted group of second input data is less than or equal to N/2, the inputted group of second input data is outputted as the corresponding group of first intermediate data, and one bit of the inversion flag data corresponding to the inputted group of second input data is set to low.

The write operation circuit provided by embodiments of the present disclosure is applied to a semiconductor memory whose global bus transmission structure is a Precharge-High architecture. The number of inversions of the internal global bus can be reduced, the current may be reduced significantly, and power consumption may be decreased.

In the description of this specification, descriptions of reference terms "one embodiment", "some embodiments", "example", "specific example", or "some examples" mean that a particular feature, structure, material, or characteristic described in in conjunction with the embodiment is included in at least one embodiment of the present disclosure. Moreover, the described specific features, structures, materials or characteristics can be combined in any one or more embodiments or examples in a suitable manner. In addition, if there is no conflict with each other, those of ordinary skill in the art can combine different embodiments or examples and combine the features of the different embodiments or examples described in this specification.

Furthermore, the described features, structures or characteristics may be combined in one or more embodiments in any suitable manner. However, those of ordinary skill in the art will understand that the technical solutions of the present disclosure can be practiced without one or more of the specific details, or practiced by using other methods, components, materials, devices, steps, and the like. In other cases, well-known structures, methods, devices, implementations, materials, or operations are not shown or described in detail to avoid obscuring various aspects of the present application.

The terms "first" and "second" are only used for descriptive purposes, and should not be understood as indicating or implying relative importance or implicitly indicating the number of described technical features. Thus, the feature defined with "first" and "second" may explicitly or implicitly include one or more of such features. In the description of the present application, "plurality" refers to two or more than two, unless otherwise specifically defined.

It should be noted that although various steps of the method in this disclosure are described in a specific order in the drawings, it is not required or implied that the steps must be performed in the specific order, or that all the shown steps must be performed to achieve the desired result. Additionally or alternatively, some steps may be omitted, multiple steps may be combined into one step for execution, and/or one step may be divided into multiple steps for execution, etc. The above drawings are merely schematic illustrations of the processing included in the method according to the exemplary embodiments of the present disclosure, and are not intended for limitation. It is easy to understand that the processing shown in the above drawings does not indicate or limit the time sequence of these processing. In addition, it is easy to understand that these processes can be executed synchronously or asynchronously in, for example, multiple modules.

Although the principle of the present disclosure have been described with reference to specific embodiments, it should be understood that the present disclosure is not limited to the specific embodiments disclosed, and the division of various aspects does not mean that the features in these aspects cannot be combined for benefits, this division is only for the convenience of description. This disclosure is intended to cover various modifications and equivalent arrangements included in the scope of the appended claims.

The foregoing descriptions are merely specific embodiments of the present disclosure, but are not intended to limit the protection scope of the present disclosure. Any modifications or substitutions easily made by those of ordinary skill in the art in light of the teachings disclosed herein shall fall within the protection scope of the present disclosure. Therefore, the protection scope of the present disclosure shall be subject to the protection scope of the claims.

## Claims

1. A write operation circuit in a semiconductor memory (20), comprising:
a data determination module (23), which is configured to determine, according to a number of low-level bits in input data of the semiconductor memory (20), whether to invert the input data to generate inversion flag data and first intermediate data;
a module (22), which comprises a plurality of NMOS transistors (222) and a plurality of first inverters (224), a gate electrode of each of the plurality of NMOS transistors(222) is connected to the data determination module through a respective one of the plurality of first inverters to receive second intermediate data, a drain electrode of each of the plurality of NMOS transistors (222) is connected to a global bus of the write operation circuit, the module (22) is configured to determine whether to invert the global bus according to the second intermediate data, wherein the second intermediate data is inverted data of the first intermediate data;
a data receiving module (25), which is connected to a storage bank (26) and is configured to receive global bus data through the global bus, receive the inversion flag data through an inversion flag signal line, decode the global bus data according to the inversion flag data and write decoded data into the storage bank (26) of the semiconductor memory, (20), the decoding comprises determining whether to invert the global bus data, wherein an input terminal of the data receiving module (25) is connected to the global bus and the inversion flag signal line; and
a precharge module (27), which is connected to a precharge signal line and is configured to set an initial state of the global bus to high.

2. The write operation circuit according to claim 1, further comprising: a serial-to-parallel conversion circuit (21), which is connected between a DQ port (24) of the semiconductor memory (20) and the data determination module (23) and is configured to perform serial-to-parallel conversion on first input data at the DQ port (24) to generate second input data;
wherein the data determination module (23) is configured to determine, according to a number of low-level bits in the second input data, whether to invert the second input data to generate the inversion flag data and first intermediate data.

3. The write operation circuit according to claim 2, wherein the second input data is divided into M groups, the inversion flag data has M bits, the M bits of the inversion flag data and the M groups of second input data are in one-to-one correspondence, each of the M groups of second input data has N bits, N and M are integers greater than 1;
wherein the data determination module (23) is configured to, in a case where a number of low-level bits in an inputted group of second input data is greater than N/2, output inversed data of the inputted group of second input data as a group of first intermediate data corresponding to the inputted group of second input data and set one bit of the inversion flag data corresponding to the inputted group of second input data to high; and in a case where the number of low-level bits in the inputted group of second input data is less than or equal to N/2, output the inputted group of second input data as the group of first intermediate data corresponding to the inputted group of second input data and set one bit of the inversion flag data corresponding to the inputted group of second input data to low.

4. The write operation circuit according to claim 2, wherein the data determination module (23) comprises:
a data determination unit (231), wherein an input terminal of the data determination unit(231)is connected to the serial-to-parallel conversion circuit (21), an output terminal of the data determination unit (231) is connected to the inversion flag signal line, and the data determination unit (231) is configured to set the inversion flag data to high in a case where the number of low-level bits in the second input data is greater than a preset value, and set the inversion flag data to low in a case where the number of low-level bits in the second input data is less than or equal to the preset value; and
a data selector (232), wherein an input terminal of the data selector (232) is connected to the data determination unit (231) and is configured to receive the second input data through the data determination unit (231), the input terminal of the data selector (232) further receives the inversion flag data through the inversion flag signal line, an output terminal of the data selector (232) is connected to an input terminal of the first inverter (224), and the data selector (232) is configured to output inverted data of the second input data as the first intermediate data in a case where the inversion flag data is high, and output the original second input data as the first intermediate data in a case where the inversion flag data is low.

5. The write operation circuit according to claim 4, wherein the data selector (231) comprises a plurality of data selection units (232'), and each of the plurality of data selection units (232') comprises:
a second inverter (232A), wherein an input terminal of the second inverter (232A) receives the inversion flag data through the inversion flag signal line;
a third inverter (232B), wherein an input terminal of the third inverter (232B) is connected to the data determination unit (231) and is configured to receive the second input data from the data determination unit (231);
a first transmission gate (232C), wherein an input terminal of the first transmission gate (232C) is connected to an output terminal of the third inverter (232B), an output terminal of the first transmission gate (232C) is connected to the input terminal of the first inverter (224) and is configured to output the first intermediate data, a negative control terminal of the first transmission gate (232C) is connected to an output terminal of the second inverter (232A), and a positive control terminal of the first transmission gate (232C) receives the inversion flag data through the inversion flag signal line; and
a second transmission gate (232D), wherein an input terminal of the second transmission gate (232D) is connected to the data determination unit (231) and is configured to receive the second input data from the data determination unit (231), an output terminal of the second transmission gate (232D) is connected to the input terminal of the first inverter (224) and is configured to output the first intermediate data, a negative control terminal of the second transmission gate (232D) receives the inversion flag data through the inversion flag signal line, and a positive control terminal of the second transmission gate (232D) is connected to the output terminal of the second inverter (232A).

6. The write operation circuit according to claim 3, wherein the global bus data is arranged in M groups, and the M bits of the inversion flag data and the M groups of global bus data are in one-to-one correspondence, the data receiving module (23) comprises M data receiving units (250), and each of the M data receiving units (250) is connected to the storage bank and is configured to decode, according to one bit of the inversion flag data, a corresponding group of global bus data.

7. The write operation circuit according to claim 6, wherein each of the M data receiving units (250) comprises:
a fourth inverter (251), wherein an input terminal of the fourth inverter (251) receives the inversion flag data through the inversion flag signal line;
a fifth inverter (252), wherein an input terminal of the fifth inverter (252) receives the global bus data through the global bus;
a third transmission gate (253), wherein an input terminal of the third transmission gate (253) is connected to an output terminal of the fifth inverter (252), an output terminal of the third transmission gate (253) is connected to the storage bank (26) and is configured to output the decoded data to the storage bank (26), a negative control terminal of the third transmission gate (253) is connected to an output terminal of the fourth inverter (251), and a positive control terminal of the third transmission gate (253) receives the inversion flag data through the inversion flag signal line; and
a fourth transmission gate (254), wherein an input terminal of the fourth transmission gate (254) receives the global bus data through the global bus, an output terminal of the fourth transmission gate (254) is connected to the storage bank (26) and is configured to output the decoded data to the storage bank (26), a negative control terminal of the third transmission gate (254) receives the inversion flag data through the inversion flag signal line, and a positive control terminal of the third transmission gate (254) is connected to the output terminal of the fourth inverter.

8. The write operation circuit according to claim 1, wherein the precharge module (27) comprises a plurality of PMOS transistors (221) and a plurality of hold circuits (223), a gate electrode of each of the plurality of PMOS transistors (221) is connected to the precharge signal line, a drain electrode of each of the plurality of PMOS transistors (221) is connected to the global bus, and an input terminal and an output terminal of each of the plurality of hold circuits (223) are both connected to the global bus.

9. A write operation method executed by a write operation circuit, according to claims 1 to 8, in a semiconductor memory, comprising:
setting (S901) an initial state of a global bus to high;
determining (S902), according to a number of low-level bits in input data of the semiconductor memory, whether to invert the input data to generate inversion flag data and first intermediate data;
determining (S903) whether to invert global bus data according to second intermediate data, wherein the second intermediate data is inverted data of the first intermediate data;
decoding (S904) the global bus data according to the inversion flag data, wherein the decoding comprises determining whether to invert the global bus data; and
writing (S905) decoded data into a storage bank.

10. The write operation method according to claim 9, wherein determining, according to the number of low-level bits in input data of the semiconductor memory, whether to invert the input data to generate the inversion flag data and the first intermediate data comprises:
performing serial-to-parallel conversion on first input data at a DQ port to generate second input data; and
determining, according to a number of low-level bits in the second input data, whether to invert the second input data to generate the inversion flag data and the first intermediate data.

11. The write operation method according to claim 10, wherein determining, according to the number of low-level bits in the second input data, whether to invert the second input data to generate the inversion flag data and the first intermediate data comprises:
dividing the second input data into M groups, wherein each group of second input data has N bits, and M and N are integers greater than 1;
in a case where a number of low-level bits in an inputted group of second input data is greater than N/2, outputting inverted data of the inputted group of second input data as a corresponding group of first intermediate data and setting one bit of the inversion flag data corresponding to the inputted group of second input data to high; and
in a case where the number of low-level bits in the inputted group of second input data is less than or equal to N/2, outputting the inputted group of second input data as the corresponding group of first intermediate data and setting one bit of the inversion flag data corresponding to the inputted group of second input data to low.

## Patentansprüche

1. Schreiboperationsschaltung in einem Halbleiterspeicher (20), umfassend:
ein Datenbestimmungsmodul (23), das so ausgelegt ist, dass es entsprechend einer Anzahl von Low-Level-Bits in Eingangsdaten des Halbleiterspeichers (20) bestimmt, ob die Eingangsdaten zu invertieren sind, um Invertierungsflagwerte und erste Zwischendaten zu erzeugen;
ein Modul (22), das eine Vielzahl von NMOS-Transistoren (222) und eine Vielzahl von ersten Invertern (224) umfasst, wobei eine Gate-Elektrode jedes der Vielzahl von NMOS-Transistoren (222) mit dem Datenbestimmungsmodul über einen jeweiligen der Vielzahl von ersten Invertern verbunden ist, um zweite Zwischendaten zu empfangen, eine Drain-Elektrode jedes der Vielzahl von NMOS-Transistoren (222) mit einem globalen Bus der Schreiboperationsschaltung verbunden ist, das Modul (22) so ausgelegt ist, dass es bestimmt, ob der globale Bus gemäß den zweiten Zwischendaten invertiert werden soll, wobei die zweiten Zwischendaten invertierte Daten der ersten Zwischendaten sind;
ein Datenempfangsmodul (25), das mit einer Speicherbank (26) verbunden ist und so ausgelegt ist, dass es globale Busdaten über den globalen Bus empfängt, die Invertierungsflagwerte über eine Invertierungsflag-Signalleitung empfängt, die globalen Busdaten gemäß den Invertierungsflagwerten decodiert und decodierte Daten in die Speicherbank (26) des Halbleiterspeichers (20) schreibt, wobei das Decodieren das Bestimmen umfasst, ob die globalen Busdaten zu invertieren sind, wobei ein Eingangsanschluss des Datenempfangsmoduls (25) mit dem globalen Bus und der Invertierungsflag-Signalleitung verbunden ist; und
ein Vorlademodul (27), das mit einer Vorladesignalleitung verbunden ist und so ausgelegt ist, dass es einen Anfangszustand des globalen Busses auf hoch setzt.

2. Schreiboperationsschaltung nach Anspruch 1, die ferner umfasst: eine Seriell-zu-Parallel-Umwandlungsschaltung (21), die zwischen einem DQ-Anschluss (24) des Halbleiterspeichers (20) und dem Datenbestimmungsmodul (23) geschaltet ist und so ausgelegt ist, dass sie eine Seriell-zu-Parallel-Umwandlung an ersten Eingangsdaten an dem DQ-Anschluss (24) durchführt, um zweite Eingangsdaten zu erzeugen;
wobei das Datenbestimmungsmodul (23) so ausgelegt ist, dass es entsprechend einer Anzahl von Low-Level-Bits in den zweiten Eingangsdaten bestimmt, ob die zweiten Eingangsdaten zu invertieren sind, um die Invertierungsflagwerte und die ersten Zwischendaten zu erzeugen.

3. Schreiboperationsschaltung nach Anspruch 2, wobei die zweiten Eingangsdaten in M Gruppen unterteilt sind, die Invertierungsflagwerte M Bits haben, die M Bits der Invertierungsflagwerte und die M Gruppen der zweiten Eingangsdaten in Eins-zu-Eins-Entsprechung stehen, jede der M Gruppen der zweiten Eingangsdaten N Bits hat, N und M ganze Zahlen größer als 1 sind;
wobei das Datenbestimmungsmodul (23) so ausgelegt ist, dass es in einem Fall, in dem eine Anzahl von Low-Level-Bits in einer eingegebenen Gruppe von zweiten Eingangsdaten größer als N/2 ist, invertierte Daten der eingegebenen Gruppe von zweiten Eingangsdaten als eine Gruppe von ersten Zwischendaten ausgibt, die der eingegebenen Gruppe von zweiten Eingangsdaten entsprechen, und ein Bit der Invertierungsflagwerte, die der eingegebenen Gruppe von zweiten Eingangsdaten entsprechen, auf hoch setzt; und in einem Fall, in dem die Anzahl von Low-Level-Bits in der eingegebenen Gruppe von zweiten Eingangsdaten kleiner oder gleich N/2 ist, die eingegebene Gruppe von zweiten Eingangsdaten als die Gruppe von ersten Zwischendaten entsprechend der eingegebenen Gruppe von zweiten Eingangsdaten ausgibt und ein Bit der Invertierungsflagwerte entsprechend der eingegebenen Gruppe von zweiten Eingangsdaten auf niedrig setzt.

4. Schreiboperationsschaltung nach Anspruch 2, wobei das Datenbestimmungsmodul (23) umfasst:
eine Datenbestimmungseinheit (231), wobei ein Eingangsanschluss der Datenbestimmungseinheit (231) mit der Seriell-zu-Parallel-Umwandlungsschaltung (21) verbunden ist, ein Ausgangsanschluss der Datenbestimmungseinheit (231) mit der Invertierungsflag-Signalleitung verbunden ist, und die Datenbestimmungseinheit (231) so ausgelegt ist, dass sie den Invertierungsflagwert auf hoch setzt, wenn die Anzahl der Low-Level-Bits in den zweiten Eingangsdaten größer als ein voreingestellter Wert ist, und den Invertierungsflagwert auf niedrig setzt, wenn die Anzahl der Low-Level-Bits in den zweiten Eingangsdaten kleiner oder gleich dem voreingestellten Wert ist; und
einen Datenselektor (232), wobei ein Eingangsanschluss des Datenselektors (232) mit der Datenbestimmungseinheit (231) verbunden ist und so ausgelegt ist, dass er die zweiten Eingangsdaten über die Datenbestimmungseinheit (231) empfängt, wobei der Eingangsanschluss des Datenselektors (232) ferner die Invertierungsflagwerte über die Invertierungsflag-Signalleitung empfängt, ein Ausgangsanschluss der Datenauswahleinrichtung (232) mit einem Eingangsanschluss des ersten Inverters (224) verbunden ist, und die Datenauswahleinrichtung (232) so ausgelegt ist, dass sie invertierte Daten der zweiten Eingangsdaten als die ersten Zwischendaten in einem Fall ausgibt, in dem der Invertierungsflagwert hoch ist, und die ursprünglichen zweiten Eingangsdaten als die ersten Zwischendaten in einem Fall ausgibt, in dem der Invertierungsflagwert niedrig ist.

5. Schreiboperationsschaltung nach Anspruch 4, wobei der Datenselektor (231) eine Vielzahl von Datenauswahleinheiten (232') umfasst, und jede der Vielzahl von Datenauswahleinheiten (232') umfasst:
einen zweiten Inverter (232A), wobei ein Eingangsanschluss des zweiten Inverters (232A) die Invertierungsflagwerte über die Invertierungsflag-Signalleitung empfängt;
einen dritten Inverter (232B), wobei ein Eingangsanschluss des dritten Inverters (232B) mit der Datenbestimmungseinheit (231) verbunden ist und dafür ausgelegt ist, die zweiten Eingangsdaten von der Datenbestimmungseinheit (231) zu empfangen;
ein erstes Übertragungs-Gate (232C), wobei ein Eingangsanschluss des ersten Übertragungs-Gates (232C) mit einem Ausgangsanschluss des dritten Inverters (232B) verbunden ist, ein Ausgangsanschluss des ersten Übertragungs-Gates (232C) mit dem Eingangsanschluss des ersten Inverters (224) verbunden ist und so ausgelegt ist, dass er die ersten Zwischendaten ausgibt, ein negativer Steueranschluss des ersten Übertragungs-Gates (232C) mit einem Ausgangsanschluss des zweiten Inverters (232A) verbunden ist, und ein positiver Steueranschluss des ersten Übertragungs-Gates (232C) die Invertierungsflagwerte über die Invertierungsflag-Signalleitung empfängt; und
ein zweites Übertragungs-Gate (232D), wobei ein Eingangsanschluss des zweiten Übertragungs-Gates (232D) mit der Datenbestimmungseinheit (231) verbunden ist und so ausgelegt ist, dass es die zweiten Eingangsdaten von der Datenbestimmungseinheit (231) empfängt, ein Ausgangsanschluss des zweiten Übertragungs-Gates (232D) mit dem Eingangsanschluss des ersten Inverters (224) verbunden ist und ausgelegt ist, um die ersten Zwischendaten auszugeben, ein negativer Steueranschluss des zweiten Übertragungs-Gates (232D) die Invertierungsflagwerte über die Invertierungsflag-Signalleitung empfängt, und ein positiver Steueranschluss des zweiten Übertragungs-Gates (232D) mit dem Ausgangsanschluss des zweiten Inverters (232A) verbunden ist.

6. Schreiboperationsschaltung nach Anspruch 3, wobei die globalen Busdaten in M Gruppen angeordnet sind und die M Bits der Invertierungsflagwerte und die M Gruppen globaler Busdaten in Eins-zu-Eins-Entsprechung stehen, das Datenempfangsmodul (23) M Datenempfangseinheiten (250) umfasst und jede der M Datenempfangseinheiten (250) mit der Speicherbank verbunden ist und so ausgelegt ist, dass sie gemäß einem Bit der Invertierungsflagwerte eine entsprechende Gruppe globaler Busdaten decodiert.

7. Schreiboperationsschaltung nach Anspruch 6, wobei jede der M Datenempfangseinheiten (250) umfasst:
einen vierten Inverter (251), wobei ein Eingangsanschluss des vierten Inverters (251) die Invertierungsflagwerte über die Invertierungsflag-Signalleitung empfängt;
einen fünften Inverter (252), wobei ein Eingangsanschluss des fünften Inverters (252) die globalen Busdaten über den globalen Bus empfängt;
ein drittes Übertragungs-Gate (253), wobei ein Eingangsanschluss des dritten Übertragungs-Gates (253) mit einem Ausgangsanschluss des fünften Inverters (252) verbunden ist, ein Ausgangsanschluss des dritten Übertragungs-Gates (253) mit der Speicherbank (26) verbunden ist und so ausgelegt ist, dass er die decodierten Daten an die Speicherbank (26) ausgibt, ein negativer Steueranschluss des dritten Übertragungs-Gates (253) mit einem Ausgangsanschluss des vierten Inverters (251) verbunden ist, und ein positiver Steueranschluss des dritten Übertragungs-Gates (253) die Invertierungsflagwert über die Invertierungsflag-Signalleitung empfängt; und
ein viertes Übertragungs-Gate (254), wobei ein Eingangsanschluss des vierten Übertragungs-Gates (254) die globalen Busdaten über den globalen Bus empfängt, ein Ausgangsanschluss des vierten Übertragungs-Gates (254) mit der Speicherbank (26) verbunden ist und so ausgelegt ist, dass er die decodierten Daten an die Speicherbank (26) ausgibt, ein negativer Steueranschluss des dritten Übertragungs-Gates (254) die Invertierungsflagwert über die Invertierungsflag-Signalleitung empfängt und ein positiver Steueranschluss des dritten Übertragungs-Gates (254) mit dem Ausgangsanschluss des vierten Inverters verbunden ist.

8. Schreiboperationsschaltung nach Anspruch 1, wobei das Vorlademodul (27) eine Vielzahl von PMOS-Transistoren (221) und eine Vielzahl von Halteschaltungen (223) umfasst, eine Gate-Elektrode jedes der Vielzahl von PMOS-Transistoren (221) mit der Vorladesignalleitung verbunden ist, eine Drain-Elektrode jedes der Vielzahl von PMOS-Transistoren (221) mit dem globalen Bus verbunden ist, und ein Eingangsanschluss und ein Ausgangsanschluss jeder der Vielzahl von Halteschaltungen (223) beide mit dem globalen Bus verbunden sind.

9. Schreiboperationsverfahren, das von einer Schreiboperationsschaltung nach einem der Ansprüche 1 bis 8 in einem Halbleiterspeicher ausgeführt wird, umfassend:
Setzen (S90 1) eines Anfangszustands eines globalen Busses auf hoch;
Bestimmen (S902), entsprechend einer Anzahl von Low-Level-Bits in Eingangsdaten des Halbleiterspeichers, ob die Eingangsdaten zu invertieren sind, um Invertierungsflagwerte und erste Zwischendaten zu erzeugen;
Bestimmen (S903), ob die globalen Busdaten entsprechend den zweiten Zwischendaten invertiert werden sollen, wobei die zweiten Zwischendaten invertierte Daten der ersten Zwischendaten sind;
Decodieren (S904) der globalen Busdaten gemäß den Invertierungsflagwerten, wobei das Decodieren das Bestimmen umfasst, ob die globalen Busdaten zu invertieren sind; und
Speicherbank (S905) der decodierten Daten in eine Speicherbank.

10. Schreiboperationsverfahren nach Anspruch 9, wobei entsprechend der Anzahl von Low-Level-Bits in Eingangsdaten des Halbleiterspeichers bestimmt wird, ob die Eingangsdaten zu invertieren sind, um die Invertierungsflagwerte und die ersten Zwischendaten zu erzeugen:
Durchführen einer Seriell-zu-Parallel-Umwandlung an ersten Eingangsdaten an einem DQ-Anschluss, um zweite Eingangsdaten zu erzeugen; und
Bestimmen, entsprechend einer Anzahl von Low-Level-Bits in den zweiten Eingangsdaten, ob die zweiten Eingangsdaten zu invertieren sind, um die Invertierungsflagwerte und die ersten Zwischendaten zu erzeugen.

11. Schreiboperationsverfahren nach Anspruch 10, wobei entsprechend der Anzahl von Low-Level-Bits in den zweiten Eingangsdaten bestimmt wird, ob die zweiten Eingangsdaten zu invertieren sind, um die Invertierungsflagwerte und die ersten Zwischendaten zu erzeugen, umfassend:
Unterteilen der zweiten Eingangsdaten in M Gruppen, wobei jede Gruppe der zweiten Eingangsdaten N Bits hat und M und N ganze Zahlen größer als 1 sind;
in einem Fall, in dem eine Anzahl von Low-Level-Bits in einer eingegebenen Gruppe von zweiten Eingangsdaten größer als N/2 ist, Ausgeben von invertierten Daten der eingegebenen Gruppe von zweiten Eingangsdaten als eine entsprechende Gruppe von ersten Zwischendaten und Setzen eines Bits der Invertierungsflagwerte, die der eingegebenen Gruppe von zweiten Eingangsdaten entsprechen, auf hoch; und
in einem Fall, in dem die Anzahl von Low-Level-Bits in der eingegebenen Gruppe von zweiten Eingangsdaten kleiner oder gleich N/2 ist, Ausgeben der eingegebenen Gruppe von zweiten Eingangsdaten als die entsprechende Gruppe von ersten Zwischendaten und Setzen eines Bits der Invertierungsflagwerte, die der eingegebenen Gruppe von zweiten Eingangsdaten entsprechen, auf niedrig.

## Revendications

1. Circuit d'opération d'écriture dans une mémoire à semi-conducteur (20), comprenant :
un module de détermination de données (23), qui est configuré pour déterminer, en fonction d'un nombre de bits au niveau bas dans des données d'entrée de la mémoire à semi-conducteur (20), s'il faut inverser les données d'entrée afin de générer des données de drapeau d'inversion et des premières données intermédiaires ;
un module (22), qui comprend une pluralité de transistors NMOS (222) et une pluralité de premiers inverseurs (224), une électrode de grille de chaque transistor de la pluralité de transistors NMOS (222) est connectée au module de détermination de données par l'intermédiaire d'un inverseur respectif de la pluralité de premiers inverseurs pour recevoir des deuxièmes données intermédiaires, une électrode de drain de chaque transistor de la pluralité de transistors NMOS (222) est connectée à un bus global du circuit d'opération d'écriture, le module (22) est configuré pour déterminer s'il faut inverser le bus global en fonction des deuxièmes données intermédiaires, les deuxièmes données intermédiaires étant des données inversées des premières données intermédiaires ;
un module de réception de données (25), qui est connecté à un banc de stockage (26) et est configuré pour recevoir des données de bus global par le bus global, recevoir les données de drapeau d'inversion par une ligne de signal de drapeau d'inversion, décoder les données de bus global en fonction des données de drapeau d'inversion et écrire des données décodées dans le banc de stockage (26) de la mémoire à semi-conducteur (20), le décodage comprenant la détermination d'inverser ou non les données de bus global, une borne d'entrée du module de réception de données (25) étant connectée au bus global et à la ligne de signal de drapeau d'inversion ; et
un module de précharge (27), qui est connecté à une ligne de signal de précharge et est configuré pour mettre à l'état haut un état initial du bus global.

2. Circuit d'opération d'écriture selon la revendication 1, comprenant en outre : un circuit de conversion série-parallèle (21), qui est connecté entre un port DQ (24) de la mémoire à semi-conducteur (20) et le module de détermination de données (23) et est configuré pour réaliser une conversion série-parallèle sur des premières données d'entrée au niveau du port DQ (24) afin de générer des deuxièmes données d'entrée ;
dans lequel le module de détermination de données (23) est configuré pour déterminer, en fonction d'un nombre de bits au niveau bas dans les deuxièmes données d'entrée, s'il faut inverser les deuxièmes données d'entrée afin de générer les données de drapeau d'inversion et les premières données intermédiaires.

3. Circuit d'opération d'écriture selon la revendication 2, dans lequel les deuxièmes données d'entrée sont divisées en M groupes, les données de drapeau d'inversion ont M bits, les M bits des données de drapeau d'inversion et les M groupes de deuxièmes données d'entrée sont en correspondance biunivoque, chacun des M groupes de deuxièmes données d'entrée a N bits, N et M sont des entiers supérieurs à 1 ;
dans lequel le module de détermination de données (23) est configuré pour, dans le cas où un nombre de bits au niveau bas dans un groupe de deuxièmes données d'entrée introduit est supérieur à N/2, délivrer, comme groupe de premières données intermédiaires correspondant au groupe de deuxièmes données d'entrée introduit, des données inversées du groupe de deuxièmes données d'entrée introduit et mettre à l'état haut un bit des données de drapeau d'inversion correspondant au groupe de deuxièmes données d'entrée introduit ; et dans le cas où le nombre de bits au niveau bas du groupe de deuxièmes données d'entrée introduit est inférieur ou égal à N/2, délivrer, comme groupe de premières données intermédiaires correspondant au groupe de deuxièmes données d'entrée introduit, le groupe de deuxièmes données d'entrée introduit et mettre à l'état bas un bit des données de drapeau d'inversion correspondant au groupe de deuxièmes données d'entrée introduit.

4. Circuit d'opération d'écriture selon la revendication 2, dans lequel le module de détermination de données (23) comprend :
une unité de détermination de données (231), une borne d'entrée de l'unité de détermination de données (231) étant connectée au circuit de conversion série-parallèle (21), une borne de sortie de l'unité de détermination de données (231) étant connectée à la ligne de signal de drapeau d'inversion, et l'unité de détermination de données (231) étant configurée pour mettre à l'état haut les données de drapeau d'inversion dans le cas où le nombre de bits au niveau bas dans les deuxièmes données d'entrée est supérieur à une valeur prédéfinie, et mettre à l'état bas les données de drapeau d'inversion dans le cas où le nombre de bits au niveau bas dans les deuxièmes données d'entrée est inférieur ou égal à la valeur prédéfini ; et
un sélecteur de données (232), une borne d'entrée du sélecteur de données (232) étant connectée à l'unité de détermination de données (231) et étant configurée pour recevoir les deuxièmes données d'entrée par l'intermédiaire de l'unité de détermination de données (231), la borne d'entrée du sélecteur de données (232) recevant en outre les données de drapeau d'inversion par la ligne de signal de drapeau d'inversion, une borne de sortie du sélecteur de données (232) étant connectée à une borne d'entrée du premier inverseur (224), et le sélecteur de données (232) étant configuré pour délivrer, comme premières données intermédiaires, des données inversées des deuxièmes données d'entrée dans le cas où les données de drapeau d'inversion sont à l'état haut, et délivrer, comme premières données intermédiaires, les deuxièmes données d'entrée d'origine dans le cas où les données de drapeau d'inversion sont à l'état bas.

5. Circuit d'opération d'écriture selon la revendication 4, dans lequel le sélecteur de données (231) comprend une pluralité d'unités de sélection de données (232'), et chaque unité de la pluralité d'unités de sélection de données (232') comprend :
un deuxième inverseur (232A), une borne d'entrée du deuxième inverseur (232A) recevant les données de drapeau d'inversion par la ligne de signal de drapeau d'inversion ;
un troisième inverseur (232B), une borne d'entrée du troisième inverseur (232B) étant connectée à l'unité de détermination de données (231) et étant configurée pour recevoir les deuxièmes données d'entrée provenant de l'unité de détermination de données (231) ;
une première porte de transmission (232C), une borne d'entrée de la première porte de transmission (232C) étant connectée à une borne de sortie du troisième inverseur (232B), une borne de sortie de la première porte de transmission (232C) étant connectée à la borne d'entrée du premier inverseur (224) et étant configurée pour délivrer les premières données intermédiaires, une borne de commande négative de la première porte de transmission (232C) étant connectée à une borne de sortie du deuxième inverseur (232A), et une borne de commande positive de la première porte de transmission (232C) recevant les données de drapeau d'inversion par la ligne de signal de drapeau d'inversion ; et
une deuxième porte de transmission (232D), une borne d'entrée de la deuxième porte de transmission (232D) étant connectée à l'unité de détermination de données (231) et étant configurée pour recevoir les deuxièmes données d'entrée provenant de l'unité de détermination de données (231), une borne de sortie de la deuxième porte de transmission (232D) étant connectée à la borne d'entrée du premier inverseur (224) et étant configurée pour délivrer les premières données intermédiaires, une borne de commande négative de la deuxième porte de transmission (232D) recevant les données de drapeau d'inversion par la ligne de signal de drapeau d'inversion, et une borne de commande positive de la deuxième porte de transmission (232D) étant connectée à la borne de sortie du deuxième inverseur (232A).

6. Circuit d'opération d'écriture selon la revendication 3, dans lequel les données de bus global sont agencées en M groupes, et les M bits des données de drapeau d'inversion et les M groupes de données de bus global sont en correspondance biunivoque, le module de réception de données (23) comprend M unités de réception de données (250), et chacune des M unités de réception de données (250) est connectée au banc de stockage et est configurée pour décoder, en fonction d'un bit des données de drapeau d'inversion, un groupe de données de bus global correspondant.

7. Circuit d'opération d'écriture selon la revendication 6, dans lequel chacune des M unités de réception de données (250) comprend :
un quatrième inverseur (251), une borne d'entrée du quatrième inverseur (251) recevant les données de drapeau d'inversion par la ligne de signal de drapeau d'inversion ;
un cinquième inverseur (252), une borne d'entrée du cinquième inverseur (252) recevant les données de bus global par le bus global ;
une troisième porte de transmission (253), une borne d'entrée de la troisième porte de transmission (253) étant connectée à une borne de sortie du cinquième inverseur (252), une borne de sortie de la troisième porte de transmission (253) étant connectée au banc de stockage (26) et étant configurée pour délivrer les données décodées au banc de stockage (26), une borne de commande négative de la troisième porte de transmission (253) étant connectée à une borne de sortie du quatrième inverseur (251), et une borne de commande positive de la troisième porte de transmission (253) recevant les données de drapeau d'inversion par la ligne de signal de drapeau d'inversion ; et
une quatrième porte de transmission (254), une borne d'entrée de la quatrième porte de transmission (254) recevant les données de bus global par le bus global, une borne de sortie de la quatrième porte de transmission (254) étant connectée au banc de stockage (26) et étant configurée pour délivrer les données décodées au banc de stockage (26), une borne de commande négative de la troisième porte de transmission (254) recevant les données de drapeau d'inversion par la ligne de signal de drapeau d'inversion, et une borne de commande positive de la troisième porte de transmission (254) étant connectée à la borne de sortie du quatrième inverseur.

8. Circuit d'opération d'écriture selon la revendication 1, dans lequel le module de précharge (27) comprend une pluralité de transistors PMOS (221) et une pluralité de circuits de maintien (223), une électrode de grille de chaque transistor de la pluralité de transistors PMOS (221) est connectée à la ligne de signal de précharge, une électrode de drain de chaque transistor de la pluralité de transistors PMOS (221) est connectée au bus global, et une borne d'entrée et une borne de sortie de chaque circuit de la pluralité de circuits de maintien (223) étant toutes les deux connectées au bus global.

9. Procédé d'opération d'écriture exécuté par un circuit d'opération d'écriture, selon les revendications 1 à 8, dans une mémoire à semi-conducteur, comprenant :
la mise à l'état haut (S901) d'un état initial d'un bus global ;
la détermination (S902), en fonction d'un nombre de bits au niveau bas dans des données d'entrée de la mémoire à semi-conducteur, d'inverser ou non les données d'entrée afin de générer des données de drapeau d'inversion et des premières données intermédiaires ;
la détermination (S903) d'inverser ou non des données de bus global en fonction de deuxièmes données intermédiaires, les deuxièmes données intermédiaires étant des données inversées des premières données intermédiaires ;
le décodage (S904) des données de bus global en fonction des données de drapeau d'inversion, le décodage comprenant la détermination d'inverser ou non les données de bus global ; et
l'écriture (S905) de données décodées dans un banc de stockage.

10. Procédé d'opération d'écriture selon la revendication 9, dans lequel la détermination, en fonction du nombre de bits au niveau bas dans des données d'entrée de la mémoire à semi-conducteur, d'inverser ou non les données d'entrée afin de générer les données de drapeau d'inversion et les premières données intermédiaires comprend :
la réalisation d'une conversion série-parallèle sur des premières données d'entrée au niveau d'un port DQ afin de générer des deuxièmes données d'entrée ; et
la détermination, en fonction d'un nombre de bits au niveau bas dans les deuxièmes données d'entrée, d'inverser ou non les deuxièmes données d'entrée afin de générer les données de drapeau d'inversion et les premières données intermédiaires.

11. Procédé d'opération d'écriture selon la revendication 10, dans lequel la détermination, en fonction du nombre de bits au niveau bas dans les deuxièmes données d'entrée, d'inverser ou non les deuxièmes données d'entrée afin de générer les données de drapeau d'inversion et les premières données intermédiaire comprend :
la division des deuxièmes données d'entrée en M groupes, chaque groupe de deuxièmes données d'entrée ayant N bits, et M et N étant des entiers supérieurs à 1 ;
dans le cas où un nombre de bits au niveau bas dans un groupe de deuxièmes données d'entrée introduit est supérieur à N/2, la délivrance, comme groupe de premières données intermédiaires correspondant, de données inversées du groupe de deuxièmes données d'entrée introduit et la mise à l'état haut d'un bit des données de drapeau d'inversion correspondant au groupe de deuxièmes données d'entrée introduit ; et
dans le cas où le nombre de bits au niveau bas du groupe de deuxièmes données d'entrée introduit est inférieur ou égal à N/2, la délivrance, comme groupe de premières données intermédiaires correspondant, du groupe de deuxièmes données d'entrée introduit et la mise à l'état bas d'un bit des données de drapeau d'inversion correspondant au groupe de deuxièmes données d'entrée introduit.
